# EUROPEAN PATENT APPLICATION

(11) **EP 1 143 497 A1**
(43) Date of publication of application: **10.10.2001**
(21) Application number: 99973166.4
(22) Date of filing: 26.11.1999
(51) Int. Cl.: H01L 21/3065

(54) **PLASMA ETCHING APPARATUS**

(30) Priority: 27.11.1998 JP 33688698
(71) Applicant: TOKYO ELECTRON LIMITED, Minato-ku, Tokyo 107-8481 (JP)
(72) Inventor: NAGAHATA, Kazunori, Nakakoma-gun, Yamanashi 400-0111 (JP)
(74) Representative: HOFFMANN - EITLE
(86) International application number: JP9906619
(87) International publication number: WO0033369

(57) **Abstract**

The constitution comprises a chamber 2 for containing a semiconductor wafer W, an upper electrode 21 and a lower electrode (susceptor) 5 disposed in the chamber 2, a first high frequency applying mechanism 100 for applying a high frequency of 27 MHz or more to the upper electrode 21, a second high frequency applying mechanism 200 for applying high frequencies 1.5 MHz or more and lower than that of the first high frequency applying mechanism 100, to the upper electrode 21 and lower electrode 5, at same frequency in reverse phase to each other, an exhaust device 35 for maintaining a specified decompressed state in the chamber 2, and a process gas supply mechanism 30 for feeding a process gas into the chamber 2, in which a plasma is formed by forming a high frequency electric field between the electrodes, with the wafer W held on the lower electrode 5, and the wafer W is processed by this plasma.

## Description

### Technical Field

The present invention relates to a plasma etching apparatus for processing a substrate such as a semiconductor substrate, with plasma.

### Background Art

In a manufacturing process of a semiconductor device, a plasma etching such as etching with plasma is widely applied to substrates to be processed such as semiconductor wafers.

Various types are used in the plasma etching apparatus, and the capacitive coupling type parallel plate plasma processing apparatus is in the mainstream among them.

In the capacitive coupling parallel plate plasma etching apparatus, a pair of parallel plate electrodes (upper and lower electrodes) are disposed in a chamber, a process gas is fed into the chamber, and a high frequency is applied to one electrode to form a high frequency electric field between the electrodes, so that a plasma of the process gas is formed by this high frequency electric field to process the semiconductor wafer with the plasma.

When etching a film on a semiconductor wafer, for example, an oxide film by such capacitive coupling type parallel plate plasma etching apparatus, by evacuating the chamber to a medium pressure for forming a plasma of the medium density, optical radical control is possible, and an appropriate plasma state can be obtained, so that etching of high stability and repeatability is realized a high selection ratio.

More specifically, there is disclosed in Dry Process Symposium 1997, p. 385-390, a plasma-forming high frequency of 27.12 MHz is applied to the upper electrode to form a plasma, and a high frequency of 800 kHz is applied to the lower electrode to lead in ions generated by the plasma, thereby making it possible to realize the favorable etching at pressure of 20 to 100 mTorr.

Recently, however, as the design rule of the USLI is becoming finer and a higher aspect ratio is demanded in the hole shape, it is not always sufficient in the conventional conditions.

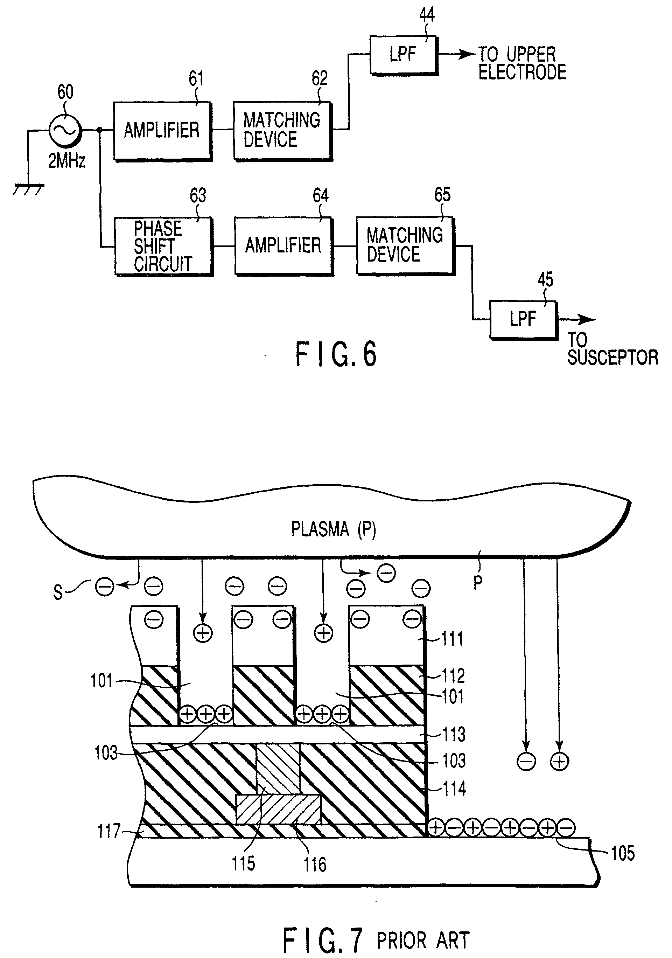

The portion of a resist layer 111 near a plasma sheath S is negatively charged during etching, as shown in FIG. 7. As a result, in electrons from a plasma P, transverse momentum is increased, and electrons are prevented from reaching the inside of a contact hole 101 having big aspect ratio. But, positive ions can reach the contact hole due to the acceleration by the plasma sheath, therefore a base 103 of the contact hole comes to be positively charged. On the other hand, without difficulty, electrons and ions can reach a space portion 105 in which any contact hole is not formed. Consequently, a high electric field is applied to a thin insulated film 117 under a gate electrode 116, therefore a breakdown, so-called shading damage, may be caused. In FIG. 7, numeral numbers 112 and 114 show insulating films (SiO₂), numeral number 113 an aluminum wiring, and numeral number 115 a gate wiring.

An object of the invention is to provide a plasma etching apparatus which can obtain a proper plasma state, meet the finer design trend, and hard to have the shading damage.

### Disclosure of Invention

The present inventor accumulated intensive studies about a plasma etching apparatus which can meet the finer design trend if necessary, and discovered that the plasma can be formed at a lower pressure, while maintaining the radical dissociation controllability equivalent to that of the conventional capacitive coupling type parallel plate plasma processing apparatus, forming the plasma of higher density, and meeting the finer design trend, by elevating the frequency of the high frequencies applied to the upper electrode and lower electrode, and applying frequencies of, for example, 60 MHz to the upper electrode and 2 MHz to the lower electrode.

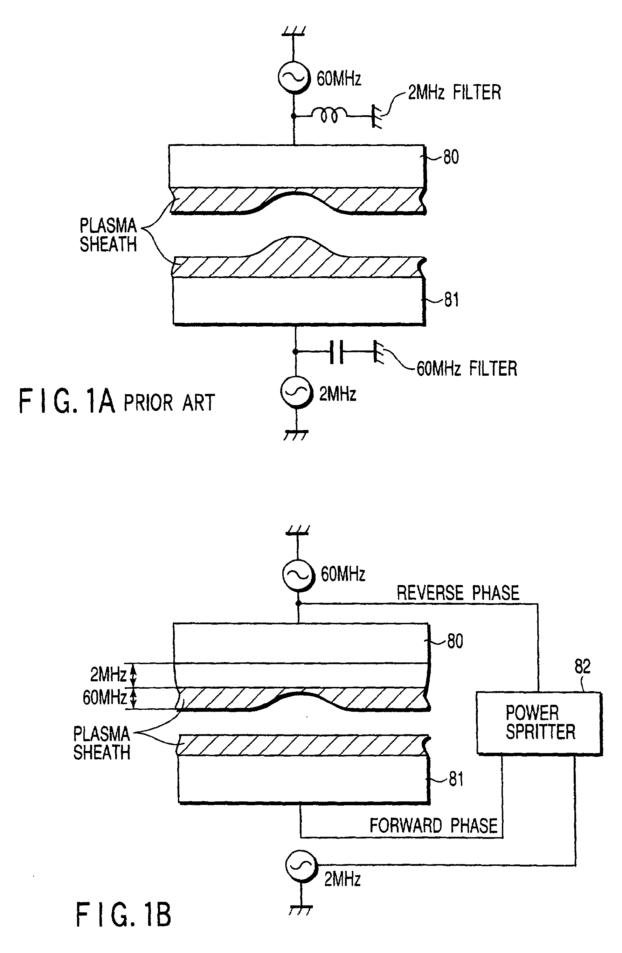

When the frequency of the high frequency applied to the upper electrode is elevated, however, it is known to cause another problem of deterioration of uniformity of etching. That is, as shown in FIG. 1A, the plasma sheath on the upper electrode 80 is extremely thin in the central part of the electrode, while the plasma sheath on the lower electrode 81 is to be thick in the central part of the electrode, and thus non-uniformity of plasma occurs.

This is because the higher harmonics generated by application of the high frequency form standing waves within the plane of the upper electrode 80. That is, the standing waves are larger in amplitude in the central part of the electrode, and as the standing waves contribute to the plasma near the upper electrode, the sheath in the central part of the upper electrode becomes thinner as compared with that of the peripheral portion. However, when the frequency applied to the upper electrode is relatively low as in the prior art, for example, less than 50 MHz, the plasma density is not high, and hence the plasma sheath is thick and effects of the standing waves on plasma uniformity are small. When the frequency is less than 50 MHz, wavelength of the higher harmonics is larger than the diameter of the upper electrode, therefore effects of the standing waves are decreased.

When the frequency of the high frequency applied to the upper electrode is higher and thus the plasma density increases, the thickness of the plasma sheath becomes thin on the whole, and if the central plasma sheath of the electrode has effects of the standing waves, in an extreme case, the plasma sheath is extremely thin in the central part of the electrode as shown in the figure, and the uniformity of plasma is impaired.

On the other hand, as for the plasma sheath of the lower electrode 81, since the plasma sheath is thin in the central part of the upper electrode, the capacitance in this area becomes larger and the current is concentrated and flows through a 2 MHz filter, so that the plasma sheath becomes thick. Accordingly, ions in the central portion of plasma are further accelerated, and the etching rate in the central part of the wafer becomes higher than that at the wafer peripheral part, and whereby the uniformity of the etching is lower.

Then, the present inventor accumulated intensive studies to eliminate the above defects, and discovered that the specific high frequencies are applied to both electrodes, so that a thickness of the plasma sheath may be increased, thereby making a variation in thickness of the plasma sheath to be small.

Furthermore, the present inventor also discovered that it is hard to cause the shading damage when the high frequency electric powers of the specific frequency are applied to both electrodes, at same frequency in substantially reverse phase or phase similar to said phase.

Furthermore, the plasma processing apparatus in which high frequencies is applied to an upper electrode, and low frequencies in mutually reverse phase are applied to the upper and lower electrodes, is disclosed in Pat. Appln. KOKAI Publication No. 7-302786 and Pat. Appln. KOKAI Publication No.8-31596. But such an apparatus may not solve the problem of the present invention.

The present invention is made standing on these accessibilities, according to a first aspect of the invention, there is provided a plasma etching apparatus comprising a chamber for containing a substrate to be processed, first and second electrodes disposed at a predetermined distance oppositely to each other in the chamber, first high frequency applying means for applying a high frequency electric power of 50 MHz or more to the first electrode, second high frequency applying means for applying high frequency electric power to the second electrode, exhaust means for maintaining a specified decompressed state in the chamber, and process gas feeding means for feeding a process gas into the chamber, in which a plasma of the process gas is formed by forming a high frequency electric field between the first and second electrodes, with the substrate to be processed held on the second electrode, and the substrate is etched by this plasma as specified, and;
the second high frequency applying means apply a high frequency to the first electrode for making the plasma sheath formed on said first electrode to be thick.

According to the second aspect of the invention, there is provided a plasma etching apparatus comprising a chamber for containing a substrate to be processed, first and second electrodes disposed at a predetermined distance oppositely to each other in the chamber, first high frequency applying means for applying a high frequency electric power of 50 MHz or more to the first electrode, second high frequency applying means for applying a high frequency electric powers of more than 2 MHz and lower than that of the first high frequency applying means, to the first and second electrodes, at same frequency in substantially reverse phase to each other, exhaust means for maintaining a specified decompressed state in the chamber, and process gas feeding means for feeding a process gas into the chamber, in which a plasma of the process gas is formed by forming a high frequency electric field between the first and second electrodes, with the substrate to be processed held on the second electrode, and the substrate is etched by this plasma as specified, and;
the second high frequency applying means apply the high frequency electric power to the first electrode, whereby the plasma sheath formed on said first electrode is increased in thickness.

According to the third aspect of the invention, there is provided a plasma etching apparatus comprising a chamber for containing a substrate to be processed, first and second electrodes disposed at a predetermined distance oppositely to each other in the chamber, first high frequency applying means for applying a high frequency electric power of 50 MHz or more to the first electrode, second high frequency applying means for applying a high frequency electric powers of 2 MHz or more and lower than that of the first high frequency applying means, to the first and second electrodes, at same frequency in substantially reverse phase (180° ± 45°) to each other, exhaust means for maintaining a specified decompressed state in the chamber, and process gas feeding means for feeding a process gas into the chamber, in which a plasma of the process gas is formed by forming a high frequency electric field between the first and second electrodes, with the substrate to be processed held on the second electrode, and the substrate is etched by this plasma as specified, and;
the second high frequency applying means apply the high frequency electric power to the first electrode, whereby the plasma sheath formed on said first electrode is increased in thickness.

In the present invention, having the first high frequency applying means for applying a high frequency of 50 MHz or more to the first electrode, and the second high frequency applying means for applying high frequency electric power to not only the second electrode but the first electrode to make the plasma sheath formed on said first electrode to be thick, if the plasma sheath has effects of standing waves, the degree of lowering of the uniformity of plasma is relatively small, whereby the state of plasma may be uniform. More specifically the second high frequency applying means apply high frequencies of 2 MHz or more and lower than that of the first high frequency applying means, to the first and second electrodes, at same frequency in substantially reverse phase to each other, and so the first electrode is applied with both the high frequency from the first high frequency applying means and the high frequency of a relatively lower frequency from the second high frequency applying means. Therefore, as shown in FIG. 1B, the plasma sheath of the upper electrode is increased in thickness as the plasma sheath corresponding to the frequency (for example, 60 MHz) of the first high frequency applying means is combined with the plasma sheath corresponding to the frequency (for example, 2 MHz) of the second high frequency applying means of a lower frequency, and moreover since the plasma sheath corresponding to 2 MHz is thicker than the plasma sheath corresponding to 60 MHz, if the plasma sheath has effects of standing waves, the degree of lowering of the uniformity of plasma is smaller. Still more, as the plasma sheath of the upper electrode is thus increased in thickness, capacitance changes due to effects of standing waves are smaller, and the current flowing in the lower electrode is uniform, and the plasma sheath of the lower electrode is almost uniform as shown in the diagram. Therefore, according to the invention, it is applicable to finer design by the plasma of high density, and the uniformity of etching is assured by the uniform plasma. Incidentally, FIG. 1 B shows the state of application of high frequencies (frequency of 2 MHz) of reverse phase to each other to the upper electrode and lower electrode by using a power splitter 82 as the second high frequency applying means.

In addition, the high frequency electric powers applied by the second high frequency applying means to the first and second electrodes are in substantially reverse phase, therefore the strength of the electric field at the sheath portion is always kept to be higher than the constant value. Consequently, the space electric potential of plasma may be higher, and the density of plasma may be higher as the ionization rate is increased, whereby ions and electrons are highly energized. The dissociation rate at the electrode peripheral part also may be increased, and so fast electron flux is increased. As a result, electrons in plasma come to easily reach the base of the contact hole, and may counteract positive charge in the hole, thereby making it possible that it is hard to cause the shading damage.

As such, effects above mentioned are conspicuously made by applying the high frequency electric powers in substantially reverse phase to each other to the first and second electrodes as above mentioned. These effects can also be made in phase similar to the mutually reverse phase.

More specifically, if a phase difference of both powers is 180° ± 45° it is possible to obtain desired effects.

The frequency of the first high frequency applying means is 50 MHz or more because it is hard to obtain the desired high density of plasma if lower than this, and the required finer design cannot be satisfied, and if less than 50 MHz, the problem itself to be solved by the invention does not occur.

According to the second aspect of the invention above mentioned, the second high frequency applying means may be constructed to comprise a power source of the high frequency of 2 MHz or more but lower than that of the first high frequency applying means, and a transformer for distributing an electric power of the high frequency power source into the first and second electrodes.

According to the second and third aspects of the invention above mentioned, the frequency of the second high frequency applying means is 2 MHz or more because, if the frequency is 2 MHz or more, a significant damage when ions are led into the substrate to be processed may be minified by preventing ions from being in compliance with.

According to the second and third aspects of the invention above mentioned, the second high frequency applying means may be constructed by a high frequency oscillator of which frequency is 2 MHz or more and lower than that of the first high frequency applying means, an amplifying means for amplifying the high frequency to apply given high frequency electric powers to the first and second electrodes respectively, and a phase shifting means for shifting a high frequency phase applied to the first or second electrodes.

According to the second and third aspects of the invention above mentioned, the frequency of the second high frequency applying means is preferably 2 to 27 MHz. The frequencies of the first and second high frequency applying means may be, for example, about 60 MHz for the first high frequency applying means and about 2 MHz for the second high frequency applying means. Furthermore, the second high frequency applying means preferably has a ratio that the electric power thereof for the first electrode to the electric power for the second electrode is 6 : 4 to 4 : 6.

### Brief Description of Drawings

FIG. 1A and FIG. 1B are views for describing the principle of the present invention, FIG. 1A being in accordance with the prior art, and FIG. 1B in accordance with the present invention.
FIG. 2 is a diagrammatically sectional view showing an etching apparatus according to an embodiment of the invention.
FIG. 3 is a diagram showing the result of simulating the electric potential distribution of plasma.
FIG. 4 is a graph showing the space electric potential of plasma.
FIG. 5A and FIG. 5B are graphs that show the dissociation rate at the plasma peripheral part and at bulk respectively.
FIG. 6 is a view for showing the other example of the second high frequency applying mechanism.
FIG. 7 shows the notion of the shading damage.

### Best Mode for Carrying Out of the Invention

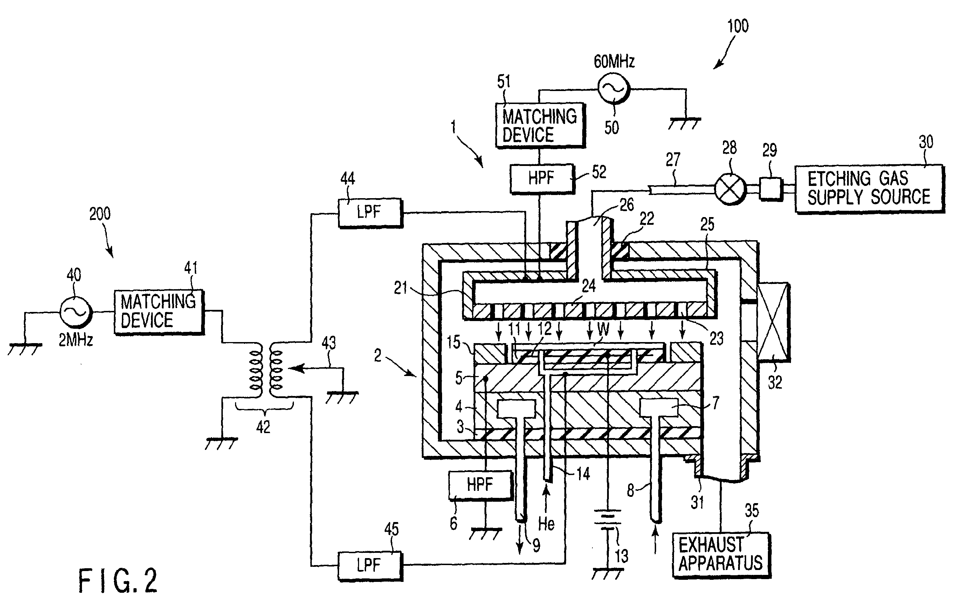

Referring now to the attached drawings, preferred embodiments of the invention are described below. FIG. 2 is a sectional view diagrammatically showing an etching apparatus according to an embodiment of the invention. This etching apparatus 1 is composed as a capacitive type parallel plate etching apparatus having a confronting upper and lower parallel electrode plates, with a plasma forming power source connected to one of them.

This etching apparatus 1 has a chamber 2 formed in a cylindrical shape of which inner surface is, for example, made of aluminum treated with alumite (anodic oxidation treatment), and this chamber 2 is safely grounded. On the bottom of the chamber 2, there is mounted a nearly columnar susceptor supporting base 4 for mounting an object to be processed, for example, a semiconductor wafer (hereinafter called simply wafer) W through an insulator 3 made of ceramic or the like, and a susceptor 5 for composing the lower electrode is provided on the susceptor supporting base 4. The susceptor 5 is grounded through a high pulse filter (HPF) 6.

Inside of the susceptor supporting the base 4, there is formed a refrigerant chamber 7. Refrigerant, such as liquid nitrogen, is introduced in the refrigerant chamber 7 through a refrigerant lead-in pipe 8 and exhausts through a refrigerant exhaust pipe 9 thereby circulating in the chamber 7, and thus its cold heat is transferred to the wafer W carried on the supporting base through the susceptor 5. Thus, the treating surface of the wafer W is controlled to a desired temperature.

The susceptor 5 is formed in a circular disk form, and an electrostatic chuck 11 of a nearly same shape as the wafer W is provided thereon. The electrostatic chuck 11 is constructed to make an electrode 12 interposed between insulators, and electrostatically attracts the wafer W thereon by, for example, a coulombic force or Johnson-Rahbeck effect when a direct-current voltage of 1.5 kV is applied, for example, from a direct-current power source 13 connected to the electrode 12.

Through the insulator 3, susceptor supporting base 4, susceptor 5, and electrostatic chuck 11, a gas passage 14 is formed for feeding heating medium, for example, He gas, to the back side of the wafer W to be processed, and the heat of the susceptor 5 is transferred to the wafer W through this heating medium, so that the wafer W is maintained at a specified temperature.

At the upper peripheral edge of the susceptor 5, an annular focus ring 15 is disposed so as to surround the wafer W placed on the electrostatic chuck 11. This focus ring 15 is made of a conductive material such as silicon, and functions to advance the uniformity of etching.

Above the susceptor 5, moreover, an upper electrode 21 is provided at a predetermined distance and parallel to the susceptor 5 oppositely. The upper electrode 21 is supported on the upper part of the chamber 2 through an insulator 22, and forms a facing surface to the susceptor 5, and is composed of an electrode plate 24 having multiple discharge holes 23, and an electrode supporting element 25 for supporting this electrode plate 24. The electrode plate 24 is exemplary made of silicon or amorphous carbon. The electrode supporting element 25 is also made of a conductive material, for example, aluminum of which surface is treated with alumite. The susceptor 5 and the upper electrode 21 are spaced from each other by, for example, about 10 to 60 mm.

In the middle of the electrode support element 25 of the upper electrode 21, a gas lead-in port 26 is provided, and a gas supply pipe 27 is connected to this gas lead-in port 26. A process gas supply source 30 is connected to this gas supply pipe 27 through a valve 28 and a mass flow controller 29. By the process gas supply source 30,a process gas for etching is supplied. For example, CF₄ gas is exemplified as such a process gas for etching.

In the bottom of the chamber 2, an exhaust pipe 31 is connected, and an exhaust device 35 is connected to the exhaust pipe 31. The exhaust device 35 has a vacuum pump such as a turbo molecular pump, so that the chamber 2 is evacuated to a specified decompressed atmosphere, for example, about 1 mTorr (0.133Pa). A gate valve 32 is provided at the sidewall of the chamber 2, and with the gate valve 32 opened, the wafer W is conveyed between the chamber 2 and a load lock chamber (not shown).

A mechanism for forming plasma is described below.

The embodiment comprise a first high frequency applying mechanism 100 for applying a power of a relatively high frequency to the upper electrode, and a second high frequency applying mechanism 200 for applying powers of a relatively low frequency of substantially reverse phase to each other to both the susceptor 5 as the lower electrode and the upper electrode 21. The second high frequency applying mechanism 200 applies high frequencies of same frequency to the susceptor 5 and upper electrode 21.

The first high frequency applying mechanism 100 has a first high frequency power source 50. The first high frequency power source 50 is connected to the upper electrode 21 through a matching device 51 and a high pass filter (HPF) 52. This first high frequency power source 50 outputs a power having a frequency of 50 MHz or more, and by applying such high frequency power, a plasma of high density can be formed in low pressure condition in the chamber 2. Furthermore the limit of frequency is actually about 200 MHz. For example, the frequency and the output of the first high frequency power source 50 are preferably 60 MHz and 2000 W typically.

The second high frequency applying mechanism 200 has a second high frequency power source 40. The high frequency power source 40 is connected to the primary side of a transformer 42 for composing a power splitter, and a grounding terminal 43 is provided at the secondary side of this transformer 42. The secondary side of this transformer 42 is connected to the susceptor 5 and the upper electrode 21 through low pass filters (LPF) 44, 45, respectively. Therefore, by moving the grounding terminal 43, the power of the high frequency power source 40 is distributed at an arbitrary ratio, for example, out of the output of 1000 W, 600 W to the susceptor 5 and 400 W to the upper electrode 21. The susceptor 5 and the upper electrode 21 are applied with high frequency powers of substantially reverse phase (differing in phase by 180 degrees) to each other. The second high frequency power source 40 outputs a power having a frequency of lower than that of the first high frequency power source 50 and not less than 2 MHz. Thus, having the frequency of more than 2 MHz, ions attracted onto the susceptor 5 have little damage on the wafer W. The frequency of the second high frequency power source 40 is preferred to be less than 27 MHz, and it is particularly preferred in a range of 2 to 13.56 MHz. The frequency of the second high frequency power source 40 is preferably, for example, 2 MHz. As above described, to prevent the shading damage effectively, the distribution ratio of the high frequency for the upper electrode 21 and the sucseptor 5 or lower electrode is preferably 4 : 6 to 6 : 4.

In thus constituted etching apparatus 1, for example, when etching the silicon oxide film (SiO₂) on the wafer W having the silicon substrate, the wafer W to be processed is, after the gate valve 32 is opened, conveyed into the chamber 2 from the load lock chamber which is not shown, and is mounted on the electrostatic chuck 11. As a direct-current is applied from the high voltage direct-current power source 13, the wafer W is electrostatically attracted onto the electrostatic chuck 11. Successively, the gate valve 32 is closed, and the chamber 2 is evacuated to a desired degree of vacuum by the exhaust device 35.

Afterwards, the valve 28 is opened, and, for example, CF₄ gas flows out from the process gas supply source 30 to get into the hollow space of the upper electrode 21 through the process gas supply pipe 27 and gas lead-in port 26 while the flow rate is being adjusted by the mass flow controller 29, and is discharged uniformly onto the wafer W, as indicated by arrow in FIG. 2, through the discharge ports 23 in the electrode plate 24.

After the pressure in the chamber 2 is maintained, for example, at 20 mTorr (2.66Pa), a high frequency of, for example, 60 MHz is applied to the upper electrode 21 from the high frequency power source 50 of the first high frequency applying mechanism 100. As a result, a high frequency electric field is generated between the upper electrode 21 and the susceptor 5 as the lower electrode, and the process gas is dissociated, and is formed into a plasma. On the other hand, from the high frequency power source 40 of the second high frequency applying mechanism 200, high frequency powers of, for example, 2 MHz in substantially reverse phase to each other (differing in phase by 180 degrees) are applied to the susceptor 5 and upper electrode 21 through the transformer 42.

The component applied to the upper electrode 21 from the second high frequency applying mechanism 200 has a function of increasing the thickness of the plasma sheath formed at the upper electrode 21 side by the high frequency of, for example, 60 MHz supplied to the upper electrode from the first high frequency applying mechanism 100, and therefore effects of higher harmonics of standing waves on non-uniformity of the plasma sheath on the surface of the upper electrode 21 are lessened, so that a uniform plasma can be formed.

On the other hand, the component applied to the lower electrode of the susceptor 5 from the second high frequency applying mechanism 200 has an action of introducing mainly ions of the gas molecules in plasma form positively onto the susceptor 5 side, and by ions assisting action, etching of higher anisotropy may be applied to the oxide film of the wafer W. In this case, since the frequency is 2 MHz or more, the wafer W is hardly damaged.

Thus, by applying a relatively high frequency of, for example, 60 MHz to the upper electrode 21, a high density plasma can be formed at low pressure. By applying, for example, 2 MHz to the susceptor 5, the selectivity and anisotropy of etching can be enhanced. Hence, fine processing is realized. In addition, it is also possible to eliminate the problem of non-uniformity of plasma caused when a high frequency of a relatively high frequency of, for example, 60 MHz is applied to the upper electrode 21, so that the uniformity of the plasma may be maintained.

The high frequency electric powers are applied in substantially reverse phase to each other from the second high frequency applying mechanism 200 to the upper electrode 21 and susceptor 5 that is the lower electrode, accordingly the variation of the sheath breadth is made to be small. As a result, the value on strength of the electric field is always kept to be higher than the constant value, therefore the electric potential may be high, and the dissociation rate increases so that the density of plasma increases, and thus ions and electrons are highly energized.

The dissociation rate at the electrode peripheral part may be increased, and so the fast electron flux may be increased. Consequently, electrons in plasma may reach to a base of the contact hole easily, and the positive charges in the hole may be neutralized, thereby making it possible that it is hard to cause the shading damage.

Moreover, at the secondary side of the transformer 42 of the second high frequency power source 40, and in the application route between the susceptor 5 and upper electrode 21, low pass filters (LPF) 44, 45 are interposed respectively, and hence there is no possibility of invasion of high frequency of, for example, 60 MHz from the first high frequency power source 50 into the application route. In the application route of the first high frequency power source 50, a high pass filter (HPF) 52 is placed, and hence there is no possibility of invasion of high frequency of, for example, 2 MHz, from the second high frequency power source 40 into this application route. Therefore, a stable process is realized. As far as such blocking function is available, not limited to low pass filters (LPF) 44, 45 or high pass filter (HPF) 52, other blocking means may be also employed.

Then, it will be described the result that plasma formed by the plasma processing apparatus according to the present invention is simulated.

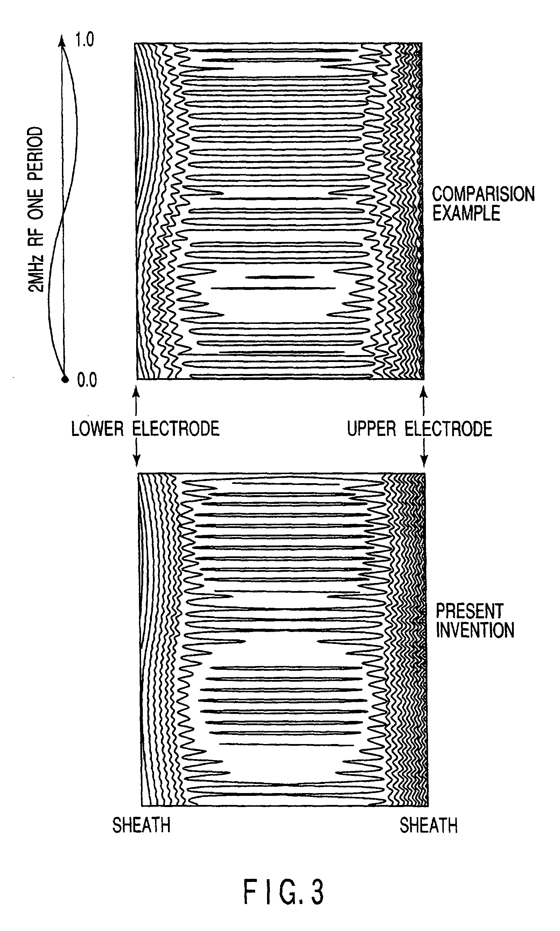

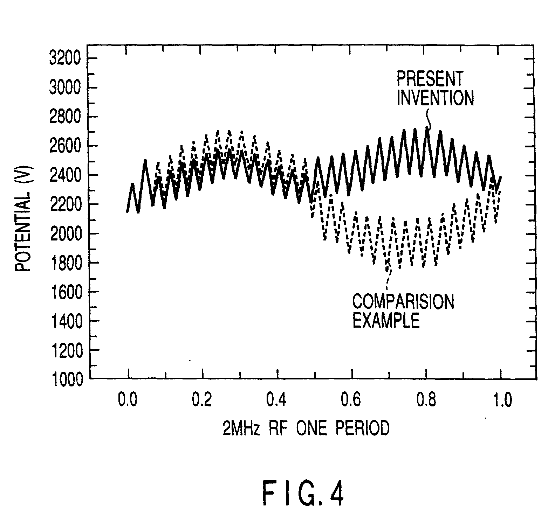

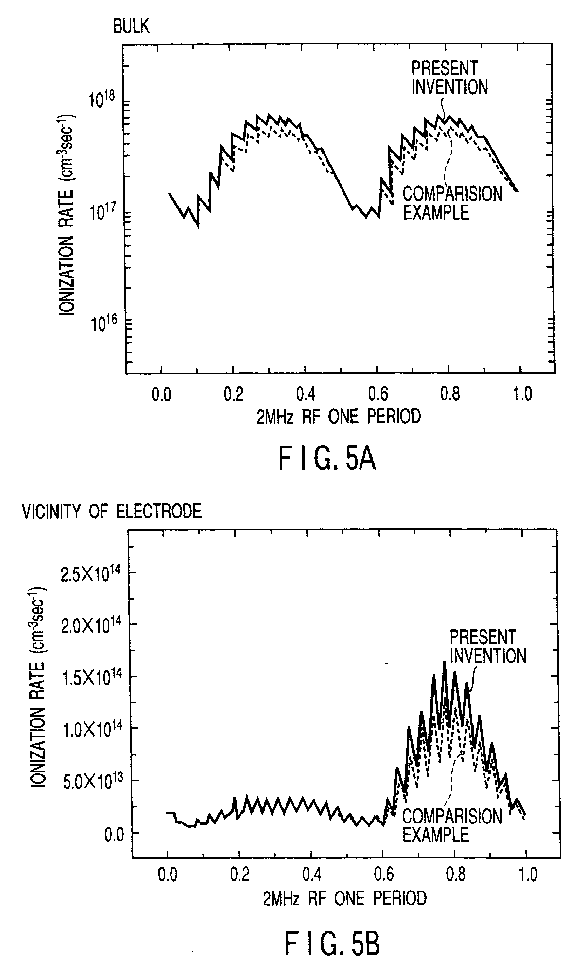

FIG. 3 denotes an electric potential distribution on the upper central part of an wafer, in the case corresponding with the present invention in which the high frequency electric power of 60 MHz is applied to the upper electrode and the powers of 2 MHz are applied to the upper and lower electrodes at the distribution ratio of 4 : 6, and in the case of the comparative instance that the high frequency electric power of 60 MHz to the upper electrode, and of 2 MHz to the lower electrode, is applied respectively. In this figure, an abscissa shows a distance in the direction perpendicular to the electrode, an ordinate shows a time for a cycle of the high frequency of 2 MHz. We will know that, the sheath width in the present invention is more assured than that of the comparative instance, and that the strength of the electric field shown as the grade of the electric potential at the sheath part denotes the value more than the constant value, as shown in this figure. For the present invention, this electric potential of plasma is higher, and the regulation is smaller as shown in FIG. 4, furthermore, the dissociation rate at that time is higher at bulk and at the electrode peripheral part, as shown in FIGS. 5A and 5B. That is to say, we will know that the density of plasma is higher in the present invention. It was shown as imulation that ions and electrons are highly energized synchronically, and the fast electron flux increases subsequently. Moreover, as a result of simulating a time taken for electrons reaching to the wafer from the plasma sheath, it was 3.3nsec for the comparative instance, and 3.2 nsec for the present invention. That is to say, we will know that the time for electrons reaching the wafer from the plasma sheath is smaller in the present invention, and that electrons are made to be fast. Consequently, electrons which reach the base 103 of the contact hole 101 shown in FIG. 7 increase and, at this part the positive charges are absorbed, so that it is hard to cause the shading damage.

As a result, it is confirmed that it is hard to make the thickness of the plasma sheath to vary and cause the shading damage, in the present invention.

As a result of carrying out the experiment of acceleration for the shading damage, yield factor was 59 % in the comparative instance, on the other hand, that was 98 % in the present invention. Furthermore, it is confirmed that, when the distribution ratio of the high frequency electric powers for the upper electrode to the lower electrode is 4 : 6 to 6 : 4, effects for preventing the shading damage are especially high. Further, when the distribution ratio of the high frequency electric power for the upper electrode to the lower electrode is 6 to 4, the selective ratio of the etching is higher than that of the comparative instant and when the distribution ratio is 4 to 6. That is because the radical distribution is higher at the wafer peripheral part by applying high electric power to the upper electrode.

The invention is not limited to the above embodiment, but may be modified in various manners. For example, in the foregoing embodiment, the so-called power splitter is used in the second high frequency applying mechanism 200, but not limited to this, any other means may be used as far as it can apply high frequencies of reverse phase to each other to both electrodes. For example, as shown in FIG. 6, a high frequency oscillator 60 capable of oscillating a high frequency of 2 MHz is provided, and it is connected to the upper electrode 21 through an amplifier 61, a matching device 62, and the low pass filter 44, and connected to the susceptor 5 through a phase shifting circuit 63, an amplifier 64, a matching device 65, and the low pass filter 45, and may shift the phase by 180 degrees to change into a reverse phase through the phase shifting circuit 63. When the frequency is high, the transformer does not function, and hence the constitution in FIG. 6 is particularly effective at high frequency.

Moreover, in the embodiment, the high frequency electric powers in mutually reverse phase are applied to the upper and lower electrodes. But, it is applicable to be in not only reverse phase but also phase similar to said phase. More specifically, if the phase shift is 180° ± 45° , desired effects may be obtained. Adjusting the shift amount of the phase shift circuit 63 in FIG. 6 substantializes such a construction.

Moreover, in the embodiment, the substrate to be processed is a semiconductor wafer, and it is etched, but not limited to this, other objects may be processed, such as a substrate for a liquid crystal display device (LCD).

### Industrial Applicability

According to the invention, as described herein, there are provided the first high frequency applying means for applying the high frequency electric power of 50 MHz or more to the first electrode, and the second high frequency applying means for applying the high frequency electric power to the second electrode, the second high frequency applying means further applying the high frequency electric power to not only the second electrode but the first electrode so as to make a plasma sheath on the first electrode to be thick. Therefore, if the plasma sheath is effected by standing waves, the degree of lowering of the uniformity of plasma is smaller, and so the state of plasma may be more equal.

More specifically, the present invention comprises the first high frequency applying means for applying the high frequency of 50 MHz or more to the first electrode and the second high frequency applying means for applying the high frequencies of 2 MHz or more, and lower than that of the first high frequency applying means, to the first and second electrodes, at same frequency in substantially reverse phase to each other, and therefore not only the high frequency by the first high frequency applying means but also the high frequency of a lower frequency by the second high frequency applying means is applied to the first electrode.

Therefore, the plasma sheath of the upper electrode is increased in thickness as the plasma sheath corresponding to the frequency of the first high frequency applying means is combined with the plasma sheath corresponding to the frequency of the second high frequency applying means of a lower frequency, and hence if the plasma sheath has effects of standing waves, the uniformity of plasma is hardly changed, and the plasma sheath of the lower electrode is almost uniform. Therefore, it is applicable to finer design by a plasma of high density, and uniformity of a plasma process is assured by a uniform plasma.

The high frequency electric powers are applied to the first and second electrodes above mentioned, therefore the variation in the thickness of the plasma sheath may be smaller, so that the value on strength of the electric field is always kept to be higher than the constant value. Therefore the electric potential may be high, and the dissociation rate increases so that the density of plasma increases, whereby ions and electrons are highly energized.

The dissociation rate at the electrode peripheral part may be increased, and so the fast electron flux may be increased. Consequently, electrons in plasma may reach a base of the contact hole easily, and the positive charge in the hole may be neutralized, thereby making it hard to cause the shading damage.

The effects above mentioned is conspicuously made by applying the high frequency electric powers in substantially reverse phase to each other to the first and second electrodes, as above mentioned. These effects can be made in phase similar to the mutually reverse phase. if a phase difference of both powers is 180° ± 45° it is possible to obtain desired effects.

## Claims

1. A plasma etching apparatus comprising:
a chamber for containing a substrate to be processed;
first and second electrodes disposed at a predetermined distance oppositely to each other in the chamber;
first high frequency applying means for applying a high frequency electric power of 50 MHz or more to the first electrode;
second high frequency applying means for applying high frequency electric power to the second electrode;
exhaust means for maintaining a specified decompressed state in the chamber; and
process gas feeding means for feeding a process gas into the chamber;
wherein a plasma of the process gas is formed by forming a high frequency electric field between the first and second electrodes, with the substrate to be processed held on the second electrode, and the substrate is etched by this plasma as specified;
said second high frequency applying means also applying a high frequency to said first electrode for making a plasma sheath formed on said first electrode to be thick.

2. A plasma etching apparatus comprising:
a chamber for containing a substrate to be processed;
first and second electrodes disposed at a predetermined distance oppositely to each other in the chamber;
first high frequency applying means for applying a high frequency of 50 MHz or more to the first electrode;
second high frequency applying means for applying high frequency electric powers of 2 MHz or more and lower than that of the first high frequency applying means, to the first and second electrodes, at same frequency in substantially reverse phase to each other;
exhaust means for maintaining a specified decompressed state in the chamber; and
process gas feeding means for feeding a process gas into the chamber;
wherein a plasma of the process gas is formed by forming a high frequency electric field between the first and second electrodes, with the substrate to be processed held on the second electrode, and the substrate is etched by this plasma as specified;
the plasma sheath formed on said first electrode being made to be thick by the high frequency electric power applied by said second high frequency applying means to the first electrode.

3. The plasma etching apparatus according to claim 2, wherein said second high frequency applying means comprise a power source of high frequency of more than 2 MHz and lower than that of the first high frequency applying means, and a transformer for distributing an electric power of the high frequency power source into the first and second electrodes.

4. A plasma processing apparatus comprising:
a chamber for containing a substrate to be processed;
first and second electrodes disposed at a predetermined distance oppositely to each other in the chamber;
first high frequency applying means for applying a high frequency of 50 MHz or more to the first electrode;
second high frequency applying means for applying high frequency electric powers of more than 2 MHz and lower than that of the first high frequency applying means, to the first and second electrodes, at same frequency in reverse phase;
exhaust means for maintaining a specified decompressed state in the chamber; and
process gas feeding means for feeding a process gas into the chamber;
wherein a plasma of the process gas is formed by forming a high frequency electric field between the first and second electrodes, with the substrate to be processed held on the second electrode, and the substrate is etched by this plasma as specified;
the plasma sheath formed on said first electrode being made to be thick by the high frequency electric power applied by said second high frequency applying means to the first electrode.

5. The plasma etching apparatus according to claim 2 or 4, **characterized in that** the second high frequency applying means include a high frequency oscillator for oscillating a frequency of 2 MHz or more and lower than that of the first high frequency applying means, an amplifying means for amplifying the high frequency to apply given high frequency electric power to the first and second electrodes respectively, and phase shifting means for shifting a high frequency phase applied to the first and second electrodes.

6. A plasma etching apparatus according to any one of claims 2 to 5, **characterized in that** the frequency of the second high frequency applying means is 2 to 27 MHz.

7. A plasma etching apparatus according to any one of claims 2 to 6, **characterized in that** the frequency of the first high frequency applying means is about 60 MHz and the frequency of the second high frequency applying means is about 2 MHz.

8. A plasma etching apparatus according to any one of claims 2 to 7, **characterized in that** the second high frequency applying means has the ratio of the electric power for said first electrode to the second electrode is 6 : 4 to 4 : 6.
